# EUROPÄISCHE PATENTSCHRIFT

(11) **EP 0 607 630 B1**
(45) Veröffentlichungstag und Bekanntmachung des Hinweises auf die Patenterteilung: **17.03.1999**
(21) Anmeldenummer: 93203471.3
(22) Anmeldetag: 10.12.1993
(51) Int. Cl.: H03H 11/26, H03H 17/08, H03K 5/135

(54) **Schaltungsanordnung zum Verzögern eines Nutzsignals**
Circuit for delaying a useful signal
Circuit pour retarder un signal utile

(30) Priorität: 15.12.1992 DE 4242201
(43) Veröffentlichungstag der Anmeldung: 27.07.1994
(73) Patentinhaber: Philips Patentverwaltung GmbH, 22335 Hamburg (DE); Koninklijke Philips Electronics N.V., 5621 BA Eindhoven (NL)
(72) Erfinder: Suwald, Thomas, c/o Philips Patentverwaltung GmbH, D-20097 Hamburg (DE)
(74) Vertreter: Peters, Carl Heinrich, Dipl.-Ing.

(56) Entgegenhaltungen:
- EP-A- 0 383 387
- PATENT ABSTRACTS OF JAPAN vol. 15, no. 82 (E-1038) 26. Februar 1991 & JP-A-02 298 112 (CANON INC) 10. Dezember 1990
- PATENT ABSTRACTS OF JAPAN vol. 15, no. 397 (E-1120) 8. Oktober 1991 & JP-A-03 160 813 (CANON INC) 10. Juli 1991
- PATENT ABSTRACTS OF JAPAN vol. 15, no. 82 (E-1038) 26. Februar 1991 & JP-A-02 298 111 (CANON INC) 10. Dezember 1990
- PATENT ABSTRACTS OF JAPAN vol. 6, no. 6 (E-089) 14. Januar 1982 & JP-A-56 129 419 (HITACHI LTD) 9. Oktober 1981
- PATENT ABSTRACTS OF JAPAN vol. 6, no. 64 (E-103) (942) 23. April 1982 & JP-A-57 005 421 (FUJITSU K. K.) 12. Januar 1982

## Beschreibung

Die Erfindung bezieht sich auf eine Schaltungsanordnung zum Verzögern eines Nutzsignals.

Es sind verschiedene Schaltungsanordnungen zum Verzögern von Nutzsignalen bekannt, die nach unterschiedlichen Konstruktionsprinzipien aufgebaut sind. So sind seit langem Verzögerungsleitungen bekannt, die auf einem Glassubstrat aufgebaut sind und mit der Laufzeit akustischer Oberflächenwellen die Verzögerung eines elektrisch vorgegebenen Signals bewirken. Andere Bauformen verwenden getaktete Schieberegister zur Verzögerung binärer Nutzsignale. Auch sind Bauformen von Verzögerungsleitungen bekanntgeworden, in denen analoge Signale in Form zeitdiskreter Signalproben durch sogenannte Eimerkettenschaltungen geleitet und in diesen verzögert werden. Alle diese bisher bekanntgewordenen Verzögerungsschaltungen haben den Nachteil, daß sie nur eine konstruktionsbedingt festgelegte Verzögerungszeit aufweisen, die im Betrieb schwer oder gar nicht verändert werden kann. Zum Beispiel ließe sich die Verzögerungszeit einer durch eine Eimerkettenschaltung gebildete Verzögerungsleitung durch Verändern der Frequenz des die Eimerkettenschaltung betreibenden Taktsignals verändern. Dadurch wird aber in einer vielfach nicht brauchbaren Weise auch die Abtastfrequenz der durch die Eimerkettenschaltung gereichten Signalproben verändert, siehe z.B. EP-A-0 383 387 [PHILIPS'].

Die Erfindung hat die Aufgabe, eine Schaltungsanordnung zum Verzögern eines Nutzsignals zu schaffen, welche im Betrieb in einfacher Weise an eine Vielzahl von unterschiedlichen Werten für die gewünschte Verzögerungszeit anpaßbar, d.h. vorzugsweise umschaltbar ist.

Diese Aufgabe wird erfindungsgemäß gelöst durch eine Schaltungsanordnung zum Verzögern eines Nutzsignals, welches in Form zeitdiskreter Signalproben in durch ein Taktsignal vorgegebenen Zeitabständen in einer Reihe von Speicheranordnungen gespeichert und aus diesen nach Ablauf einer vorgebbaren Verzögerungszeit wieder ausgelesen wird, wofür jede Speicheranordnung über je eine Eingabeschaltung mit einem Nutzsignaleingang und über je eine Ausgabeschaltung mit einem Nutzsignalausgang verbindbar und die Eingabeschaltung je einer Speicheranordnung gemeinsam mit der Ausgabeschaltung der in der Reihe nachfolgenden Speicheranordnung durch je eine Ansteuervorrichtung betätigbar ist, mit einer aus einer Kette von bistabilen Kippschaltungen gebildeten Schieberegisteranordnung, in der der Ausgang je einer der Kippschaltungen mit dem Eingang der in der Kette nachfolgenden Kippschaltung verbunden ist, jede Ansteuervorrichtung je eine der Kippschaltungen umfaßt und alle Kippschaltungen vom Taktsignal geschaltet werden, und mit einer Befehlsanordnung, die zu einem ersten Zeitpunkt der ersten Kippschaltung in der Schieberegisteranordnung einen (ersten) Startimpuls zuleitet und die Schieberegisteranordnung für eine Weiterleitung des Startimpulses durch die Kette der Kippschaltungen nach Maßgabe des Taktsignals freigibt, und die zu einem zweiten Zeitpunkt die Weiterleitung des (ersten) Startimpulses unterbricht und zugleich der ersten Kippschaltung in der Schieberegisteranordnung einen nächsten Startimpuls zuleitet und die Schieberegisteranordnung für die Weiterleitung dieses nächsten Startimpulses erneut freigibt, wobei die Zeitspanne zwischen dem ersten und dem zweiten Zeitpunkt ein wählbares, ganzzahliges Vielfaches von Perioden des Taktsignals beträgt und die Anzahl der Speicheranordnungen bzw. der Kippschaltungen mindestens diesem Vielfachen der Perioden des Taktsignals entspricht.

Die erfindungsgemäße Schaltungsanordnung ist somit bevorzugt derart aufgebaut, daß zwischen dem Nutzsignaleingang für das zu verzögernde Signal und dem Nutzsignalausgang für das verzögerte Signal eine Parallelschaltung mehrerer Speicheranordnungen für einzelne, zeitdiskrete Signalproben angeordnet ist. Diese Speicheranordnungen werden nacheinander im Rhythmus des Taktsignals, mit dem die zeitdiskreten Signalproben gewonnen werden, mit diesen Signalproben geladen und nach Ablauf der gewünschten Verzögerungszeit wieder ausgelesen. Die Anzahl der Speicheranordnungen ist damit um eins größer zu bemessen als der (ganzzahlige) Quotient zwischen der größten, gewünschten Verzögerungszeit und der Periode des Taktsignals. Bei dieser Schaltungsanordnung kann das Taktsignal unverändert bleiben auch bei Einstellung beliebiger Verzögerungszeiten, so daß es lediglich den Erfordernissen angepaßt sein muß, denen das durch zeitdiskrete Signalproben übertragene Nutzsignal hinsichtlich seiner Bandbreite unterworfen ist. Damit ist es möglich, für eine umfangreichere Signalverarbeitung, die u.a. auch eine oder mehrere Signalverzögerungen umfaßt, ein in allen Signalverarbeitungsstufen konstantes, unverändertes Taktsignal einzusetzen.

Die erfindungsgemäße Schaltungsanordnung ermöglicht darüber hinaus auch einen wesentlich flexibleren Einsatz als Verzögerungsanordnungen mit starr vorgegebener Verzögerungszeit. Die somit flexibler einsetzbare Schaltungsanordnung zum Verzögern eines Nutzsignals kann u.a. zu vereinfachten Schaltungskonzepten in der Signalverarbeitung führen.

Nach einer vorteilhaften Weiterbildung der Erfindung umfaßt die Befehlsanordnung eine voreinstellbare Zählvorrichtung, deren Zählzyklus auf das gewählte Vielfache der Perioden des Taktsignals einstellbar ist und die nach jedem Zählzyklus einen der Startimpulse abgibt. Durch diese Zählvorrichtung kann somit die Verzögerungszeit als wählbares Vielfaches der Perioden des Taktsignals in einfacher Weise durch Steuersignale bestimmt werden, wie sie in vielen umfangreichen Signalverarbeitungsanordnungen benutzt werden. Damit sind auch programmgesteuerte Änderungen der gewünschten VErzögerungszeit in einfacher Weise möglich.

Vorteilhaft umfassen die Kippschaltungen je ein vom Taktsignal gemeinsam getaktetes D-Flipflop, wodurch die Weiterleitung des Startimpulses durch die Schieberegisteranordnung sehr einfach gesteuert werden kann. Dieser Steuerung dient auch das nach einer Fortbildung der Erfindung dem Eingang jedes D-Flipflops vorgeschaltete Und-Gatter, in dem das Ausgangssignal der voraufgehenden Kippschaltung mit einem Freigabesignal von der Befehlsanordnung verknüpft wird. Damit kann die Weiterleitung der Startimpulse durch die Schieberegisteranordnung durch ein einziges Steuersignal an jeder beliebigen Stelle der Schieberegisteranordnung, d.h. zu jedem möglichen Zeitpunkt, in einfacher Weise unterbrochen werden.

Weitere Ausgestaltungen der Erfindung ergeben sich aus den übrigen Unteransprüchen.

Ein Ausführungsbeispiel der Erfindung ist in der Zeichnung dargestellt und wird im folgenden näher beschrieben. Es zeigen:
Fig. 1 ein blockschematisches Schaltbild einer erfindungsgemäßen Schaltungsanordnung zum Verzögern eines Nutzsignals,
Fig. 2 eine blockschematische Darstellung eines Ausführungsbeispiels für eine Befehlsanordnung zur Verwendung in einer Schaltungsanordnung gemäß Fig. 1,
Fig. 3 einige Signalverläufe der Schaltungsanordnung nach Fig. 1 und 2 in vereinfachter Darstellung und
Fig. 4 ein Ausführungsbeispiel für eine Kippschaltung zur Verwendung in der Schaltungsanordnung nach Fig. 1.

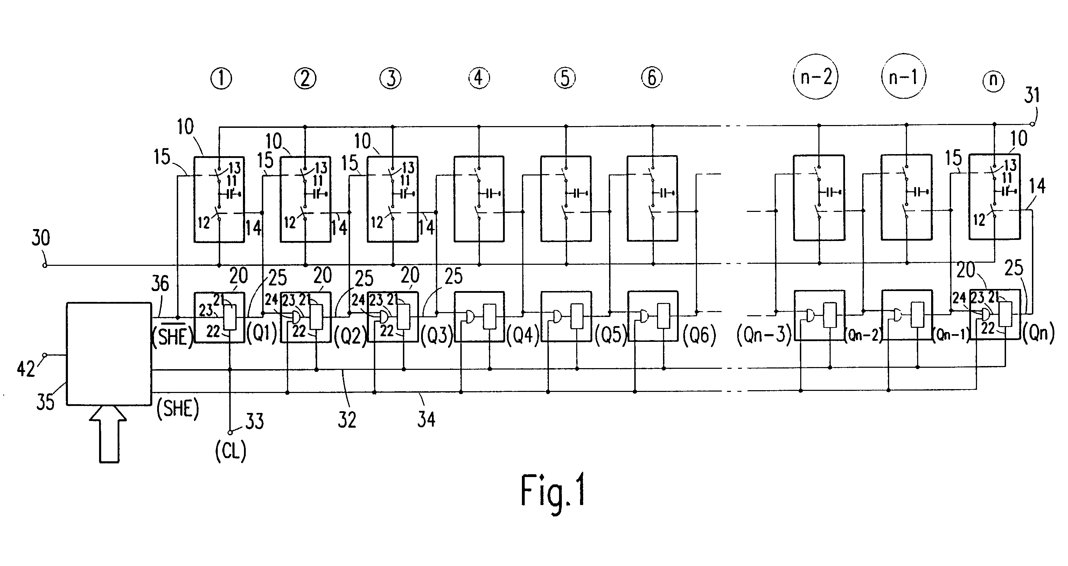

Das Ausführungsbeispiel nach Fig. 1 der erfindungsgemäßen Schaltungsanordnung zum Verzögern eines Nutzsignals umfaßt eine Reihe von Speicherzellen 10 sowie eine Kette von bistabilen Kippschaltungen 20, die jede mit Ordnungsnummern 1 bis n durchnumeriert sind. In Fig. 1 sind diese Ordnungsnummern 1 bis n zur Unterscheidung von den übrigen Bezugszeichen durch einen kleinen Kreis eingefaßt. In der Schaltungsanordnung nach Fig. 1 ist jeder Speicherzelle 10 eine Kippschaltung 20 gleicher Ordnungsnummer zugeordnet. Der Übersichtlichkeit halber sind jedoch in Fig. 1 nicht an jeder Speicherzelle 10 und an jeder bistabilen Kippschaltung 20 die Bezugszeichen eingetragen, da sie sich für alle Speicherzellen 10 bzw. Kippschaltungen 20 identisch wiederholen.

Jede Speicherzelle 10 der Schaltungsanordnung nach Fig. 1 umfaßt eine Speicheranordnung 11 für eine Signalprobe. Im vorliegenden Ausführungsbeispiel sind die Speicheranordnungen 11 als Kondensator für analoge Signalproben ausgeführt. Über eine Eingabeschaltung 12, im vorliegenden Fall als Schalter symbolisch dargestellt, ist die Speicheranordnung 11 jeder der Speicherzellen 10 mit einem Nutzsignaleingang 30 verbindbar. Ferner ist jede der Speicheranordnungen 11 über je eine Ausgabeschaltung 13, die wie die Eingabeschaltungen 12 als einfache Schalter symbolisch dargestellt sind, mit einem Nutzsignalausgang 31 verbindbar. Jede der Eingabeschaltungen 12 ist über eine Steuerleitung 14 betätigbar, und entsprechend kann jede der Ausgabeschaltungen 13 über je eine Steuerleitung 15 betätigt werden. Somit umfaßt jede der Speicherzellen 10 je eine Speicheranordnung 11, eine Eingabeschaltung 12 und eine Ausgabeschaltung 13.

Die Steuerleitung 14 der Eingabeschaltung 12 jeder der Speicherzellen 10 ist mit der Steuerleitung 15 der Ausgabeschaltung 13 der in der Reihe der Speicherzellen nachfolgenden Speicherzelle verbunden. Diese im Ausführungsbeispiel nach Fig. 1 vereinfacht als Leitungsverbindung dargestellte Verknüpfung bildet eine Ansteuervorrichtung, durch die eine gemeinsame Betätigung des Speichervorgangs in einer Speicherzelle und des Auslesevorgangs in der dazu nachfolgenden Speicherzelle, beispielsweise den Speicherzellen mit den Ordnungsnummern 1 und 2, bewerkstelligt wird.

Jede der Kippschaltungen 20 umfaßt ein D-Flipflop 21, welches mit seinem Takteingang 22 an eine allen Kippschaltungen 20 gemeinsame Taktleitung 32 angeschlossen ist. Die gemeinsame Taktleitung 32 wird über einen Taktsignalanschluß 33 mit einem gemeinsamen Taktsignal CL gespeist.

In jeder bistabilen Kippschaltung bis auf diejenige mit der Ordnungsnummer 1 ist dem D-Flipflop 21 an seinem D-Eingang 23 ein Und-Gatter 24 vorgeschaltet. Ein erster Eingang dieses Und-Gatters 24 ist mit einem Q-Ausgang 25 des D-Flipflops 21 der in der Kette voraufgehenden Kippschaltung 20 verbunden, wohingegen ein zweiter Eingang des Und-Gatters 24 an eine allen Kippschaltungen 20 und damit allen Und-Gattern 24 gemeinsame Freigabeleitung 34 angeschlossen ist. Die Freigabeleitung 34 führt ein von einer Befehlsanordnung 35 abgegebenes Freigabesignal SHE. In jedem Und-Gatter 24 wird somit ein Ausgangssignal der voraufgehenden Kippschaltung 20 mit dem Freigabesignal SHE von der Befehlsanordnung 35 verknüpft. Beispielsweise wird in dem Und-Gatter 24 der bistabilen Kippschaltung 20 mit der Ordnungsnummer 2 das mit Q1 bezeichnete Ausgangssignal der bistabilen Kippschaltung 20 mit der Ordnungsnummer 1 mit dem Freigabesignal SHE verknüpft. Die Ausgangssignale der Kippschaltungen 20 sind mit Bezugszeichen versehen, die aus einer Verbindung des großen Buchstabens Q mit der Ordnungsnummer der zugehörigen Kippschaltung 20 gebildet werden.

Die Kippschaltung 20 mit der Ordnungsnummer 1 nimmt insofern eine besondere Stellung ein, als sie im vorliegenden Ausführungsbeispiel kein Und-Gatter 24 aufweist. Statt dessen wird dem D-Eingang 23 des D-Flipflops 21 der Kippschaltung 20 mit der Ordnungsnummer 1 von der Befehlsanordnung 35 unmittelbar über eine Leitung 36 das Inverse des Freigabesignals SHE zugeführt.

Im Betrieb der Schaltungsanordnung nach Fig. 1 werden einem zu verzögernden Nutzsignal, welches über den Nutzsignaleingang 30 zugeführt wird, durch Abtastung Signalproben entnommen. Die entnommenen Signalproben werden jeweils in der Speicheranordnung 11 einer der Speicherzellen gespeichert. Nach Ablauf einer vorgebbaren Verzögerungszeit werden die in den entsprechenden Speicheranordnungen 11 enthaltenen Signalproben wieder ausgelesen und dem Nutzsignalausgang 31 als verzögertes Nutzsignal zugeführt. Die Signalproben werden aus dem dem Nutzsignaleingang 30 zugeführten Nutzsignal in durch das Taktsignal CL vorgegebenen Zeitabständen entnommen. Für eine korrekte Wiedergabe des verzögerten Nutzsignals wird dabei das Abspeichern neuer Signalproben und das verzögerte Auslesen gespeicherter Signalproben gleichzeitig durchgeführt. Damit wird ein kontinuierlicher Strom von Signalproben am Nutzsignalausgang 31 erhalten.

In der Schaltungsanordnung nach Fig. 1 wird diese Gleichzeitigkeit dadurch erreicht, daß die Steuerleitung 15 für die Ausgabeschaltung 13 einer Speicherzelle 10 mit einer bestimmten Ordnungsnummer (z.B. 3) und die Steuerleitung 14 für die Eingabeschaltung 12 an der Speicherzelle 10, die einen durch das Taktsignal vorgegebenen Zeitabstand zuvor ausgelesen wurde, d.h. die eine um 1 niedrigere Ordnungsnummer aufweist, verbunden sind. Jede dieser Verbindungen ist mit dem Q-Ausgang 25 der bistabilen Kippschaltung 20 mit derselben Ordnungsnummer wie die Speicherzelle 10, deren Steuerleitung 14 der Eingabeschaltung 12 Teil der vorstehenden Verbindung ist, zur Bildung einer gemeinsamen Ansteuervorrichtung verbunden und wird somit durch das zugehörige Ausgangssignal Q mit der entsprechenden Ordnungsnummer gesteuert. Dadurch wird sichergestellt, daß die in einer Speicheranordnung enthaltene Signalprobe ausgelesen wird und erst nach einem weiteren, durch das Taktsignal CL vorgegebenen Zeitabstand durch eine neue Signalprobe ersetzt wird. Um dies korrekt durchzuführen, wird ständig durch die aus der Kette der Kippschaltungen 20 gebildete Schieberegisteranordnung, die mit dem Taktsignal CL getaktet wird, ein Einzelimpuls hindurchgeschoben. Vorzugsweise entspricht der genannte, vorgegebene Zeitabstand einer Periodendauer des Taktsignals CL. Durch das Taktsignal CL wird einerseits die Folgefrequenz der Signalproben festgelegt, und in Zusammenhang mit der Anzahl der eingesetzten Speicherzellen 10 ergibt sich die gesamte Verzögerungszeit der Schaltungsanordnung. Diese ergibt sich aus dem durch die um 1 verminderte Anzahl der eingesetzten Speicherzellen 10 bestimmten Vielfachen der Zeitabstände, in denen die Signalproben abgespeichert werden, im vorliegenden Beispiel also dem entsprechenden Vielfachen der Periodendauer des Taktsignals CL.

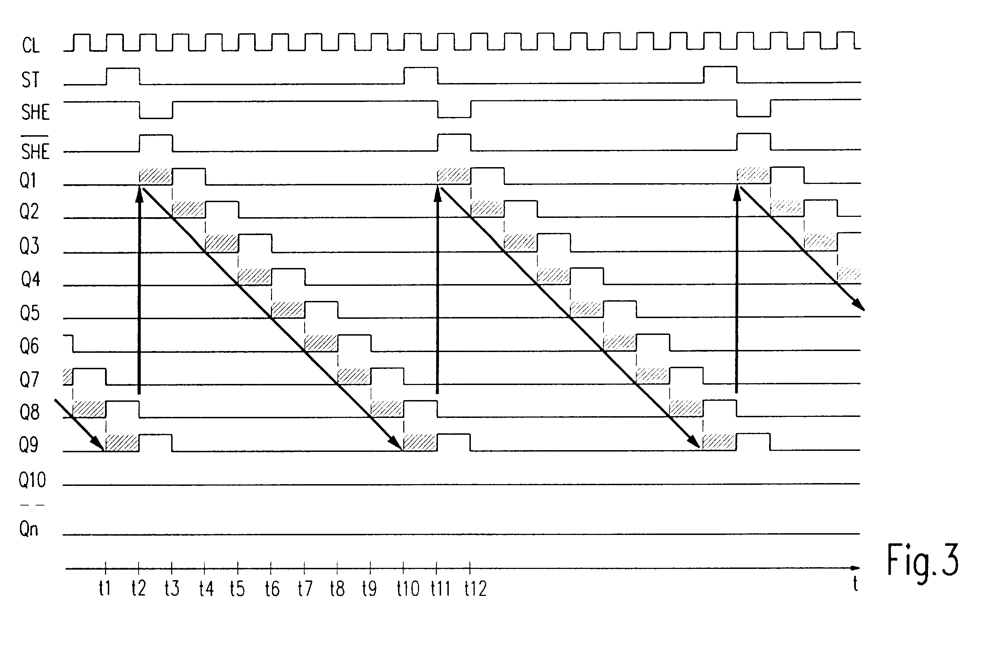

Die Funktionsweise der Schaltungsanordnung nach Fig. 1 wird im folgenden anhand der Diagramme der Fig. 3 erläutert. Synchron zu den ansteigenden Signalflanken des Taktsignals CL weist gemäß Fig. 3 das Freigabesignal SHE eine abfallende Impulsflanke auf, die zu einem Impuls von der Länge einer Periodendauer des Taktsignal CL gehört. Entsprechend weist das Inverse des Freigabesignals SHE an dieser Stelle einen positiven Impuls auf. Demgemäß wird der Kippschaltung 20 mit der Ordnungsnummer 1 über die Leitung 36 und damit dem darin enthaltenen D-Flipflop 21 an seinem D-Eingang 23 ein positiver Impuls zugeführt. Dieser Impuls beginnt zum Zeitpunkt t2 und hält zum Zeitpunkt t3, dem Zeitpunkt der nächsten, ansteigenden Flanke des Taktsignals CL, noch an. Durch die zum Zeitpunkt t3 auftretende, ansteigende Flanke im Taktsignal CL wird der positive Signalpegel des Inversen des Freigabesignals SHE über den D-Eingang 23 des D-Flipflops 21 der Kippschaltung 20 mit der Ordnungsnummer 1 in dieses D-Flipflop 21 geladen und erscheint am Q-Ausgang 25. Das hier abgegriffene Ausgangssignal Q1 weist somit zum Zeitpunkt t3 einen Anstieg von niedrigem auf hohen Signalpegel auf. Außerdem wird durch das Taktsignal CL der Impuls im Freigabesignal SHE und in dessen inverser Form beendet.

Das Freigabesignal SHE, welches von der Befehlsanordnung 35 über die Freigabeleitung 34 an alle bistabilen Kippschaltungen 20 bis auf diejenige mit der Ordnungsnummer 1 geleitet und dort einem der Eingänge der Und-Gatter 24 zugeführt wird, hat in jeder der Kippschaltungen 20 (mit den Ordnungsnummern 2 bis n) die Wirkung, die Und-Gatter 24 für eine Weiterleitung der Ausgangssignale Q1 bis Qn-1 der jeweils voraufgehenden Kippschaltung 20 an den D-Eingang 23 des zugehörigen D-Flipflops 21 freizugeben. Entsprechend liegt, da nach dem Zeitpunkt t3 das Freigabesignal SHE einen hohen Signalpegel annimmt, das Ausgangssignal Ql mit seinem hohen Signalpegel am D-Eingang 23 des D-Flipflops 21 der Kippschaltung 20 mit der Ordnungsnummer 2 an, wohingegen am D-Eingang 23 des D-Flipflops 21 der Kippschaltung 20 mit der Ordnungsnummer 1 wieder der niedrige Pegel des Inversen des Freigabesignals SHE anliegt. Beim Auftreten der nächsten ansteigenden Flanke im Taktsignal CL zum Zeitpunkt t4 wird somit in das D-Flipflop 21 der Kippschaltung 20 mit der Ordnungsnummer 1 ein niedriger Signalpegel übernommen, wohingegen in das D-Flipflop 21 der Kippschaltung 20 mit der Ordnungsnummer 2 der hohe Signalpegel übernommen wird, den das Ausgangssignal Q1 bis dahin angenommen hat. Entsprechendes tritt bei den nachfolgenden ansteigenden Flanken des Taktsignals CL zu den Zeitpunkten t5 bis - im vorliegenden Beispiel nach Fig. 3 -t11 auf. Dadurch wird durch die Kette der Kippschaltungen 20, d.h. durch die davon gebildete Schieberegisteranordnung, ein Impuls der Dauer einer Periode des Taktsignals CL hindurchgeschoben. Dies erfolgt so lange, wie das Freigabesignal SHE einen hohen Signalpegel beibehält, die Und-Gatter 24 somit freigeschaltet bleiben.

Zum (in Fig. 3 beispielhaft gewählten) Zeitpunkt tll wird nun das Freigabesignal SHE auf einen niedrigen Signalpegel zurückgeschaltet, wodurch die Und-Gatter 24 gesperrt werden. Wenn nun zum Zeitpunkt t12 die nächste ansteigende Flanke des Taktsignals CL auftritt, wird das Ausgangssignal Q9 aufgrund des gesperrten Und-Gatters 24 in der bistabilen Kippschaltung 20 mit der Ordnungsnummer 10 nicht mehr an das zugehörige D-Flipflop 21 weitergeleitet; dieses gibt statt dessen ein Ausgangssignal Q10 mit weiterhin unverändert niedrigem Signalpegel ab. Den gleichen Verlauf weisen auch alle übrigen Ausgangssignale bis zum Ausgangssignal Qn der letzten Kippschaltung 20 der Kette mit der Ordnungsnummer n auf. Die Ordnungsnummer der Kippschaltung 20, bis zu der der Impuls durch die Schieberegisteranordnung geschoben wird, ist durch die Wahl des Zeitabstandes zwischen zwei aufeinanderfolgenden Impulsen im Freigabesignal SHE, d.h. durch die Dauer anhaltend hohen Signalpegels im Freigabesignal SHE, beliebig - in Stufen mit dem Abstand einer Periodendauer des Taktsignals CL - wählbar.

Gleichzeitig mit dem - negativen - Impuls im Freigabesignal SHE ab dem Zeitpunkt t11 wird über das Inverse des Freigabesignals SHE der Kippschaltung 20 mit der Ordnungsnummer 1 ein neuer Impuls zugeführt, der entsprechend den Vorgängen zum Zeitpunkt t3 bei der nächsten ansteigenden Flanke im Taktsignal CL zum Zeitpunkt t12 vom D-Flipflop 21 der bistabilen Kippschaltung 20 mit der Ordnungsnummer 1 gespeichert wird und somit im Ausgangssignal Q1 auftritt. Dieser neue Impuls wird nun im folgenden durch die Schieberegisteranordnung hindurchgeschoben bis zum Auftreten des nächsten Impulses im Freigabesignal SHE bzw. dessen Inversem.

Durch die Ausgangssignale Q1 bis Qn-1 werden jeweils die Verbindungen der Steuerleitungen 14 und 15 für die Eingabeschaltung 12 der Speicherzelle 10 mit derselben Ordnungsnummer wie derjenigen des Ausgangssignals Q1 bis Qn-1 und die Ausgabeschaltung 13 der Speicherzelle 10 mit der jeweils nächsthöheren Ordnungsnummer derart angesteuert, daß die betreffende Eingabeschaltung 12 und Ausgabeschaltung 13 wirksam geschaltet wird. Im schematischen Schaltbild nach Fig. 1 bedeutet dies, daß die dort dargestellten Schalter geschlossen werden, so daß vom Nutzsignaleingang 30 eine Signalprobe in die Speicheranordnung 11 der Speicherzelle mit der betreffenden Ordnungsnummer eingespeichert werden kann und gleichzeitig die in der Speicheranordnung 11 der Speicherzelle 10 mit der nächsthöheren Ordnungsnummer gespeicherte Signalprobe über den Nutzsignalausgang 31 ausgelesen wird. Dies ist in Fig. 3 dadurch wiedergegeben, daß das Einspeichern der Signalproben in die zugeordnete Speicheranordnung 11 während der Zeit hohen Signalpegels des Ausgangssignals Q mit derselben Ordnungsnummer erfolgt, wohingegen das Zeitintervall, in welchem eine gespeicherte Signalprobe ausgelesen wird, als schraffiertes Feld in den Signalverlauf desjenigen Ausgangssignals Q eingetragen ist, dessen Ordnungsnummer derjenigen der ausgelesenen Speicherzelle 10 entspricht. Beispielsweise wird gleichzeitig mit dem Auftreten eines Impulses hohen Signalpegels im Ausgangssignal Q1 zwischen den Zeitpunkt t3 und t4 vom Nutzsignaleingang 30 eine Signalprobe in der Speicheranordnung 11 der Speicherzelle 10 mit der Ordnungsnummer 1 eingespeichert und zugleich die in der Speicheranordnung 11 der Speicherzelle 10 mit der Ordnungsnummer 2 gespeicherte Signalprobe an den Nutzsignalausgang 31 ausgelesen. Entsprechend ist im Signalverlauf des Ausgangssignals Q2 zwischen den Zeitpunkten t3 und t4 ein schraffiertes Feld eingezeichnet. In der Übersicht der Kurvenverläufe nach Fig. 3 erkennt man nun, daß eine in einer der Speicheranordnungen 11 gespeicherte Signalprobe unmittelbar vor dem Einspeichern einer neuen Signalprobe ausgelesen wird. So wird z.B. zwischen den Zeitpunkten t2 und t3 eine in der Speicherzelle 10 mit der Ordnungsnummer 1 gespeicherte Signalprobe ausgelesen und anschließend zwischen den Zeitpunkten t3 und t4 eine neue Signalprobe gespeichert. Diese bleibt bis zum Zeitpunkt t11 in der Speicherzelle 10 mit der Ordnungsnummer 1 abgespeichert und wird dann bis zum Zeitpunkt t12 ausgelesen, worauf sofort eine neue Signalprobe gespeichert wird. Die gespeicherte Signalprobe wird somit vom Zeitpunkt t3 bis zum Zeitpunkt tll verzögert, was einer Verzögerungszeit von acht Perioden des Taktsignals CL entspricht.

Die Ausgabeschaltung 13 der Speicherzelle 10 mit der Ordnungsnummer 1 und die Eingabeschaltung 12 der Speicherzelle 10 mit der Ordnungsnummer n werden nicht durch dasselbe Ausgangssignal Q betätigt, sondern über die Leitung 36 durch das Inverse des Freigabesignals SHE bzw. durch das Ausgangssignal Qn. Da jedoch das Ausgangssignal Q der letzten Kippschaltung 20, die in der Schieberegisteranordnung von dem durchgeschobenen Impuls durchlaufen wird, zeitgleich mit dem neuen Impuls im Inversen des Freigabesignals SHE (und damit im Freigabesignal SHE) auftritt, wird somit die Eingabeschaltung 12 der letzten für die gewählte Verzögerungszeit benutzten Speicherzelle 10 stets gleichzeitig mit der Ausgabeschaltung 13 der Speicherzelle 10 mit der Ordnungsnummer 1 betätigt.

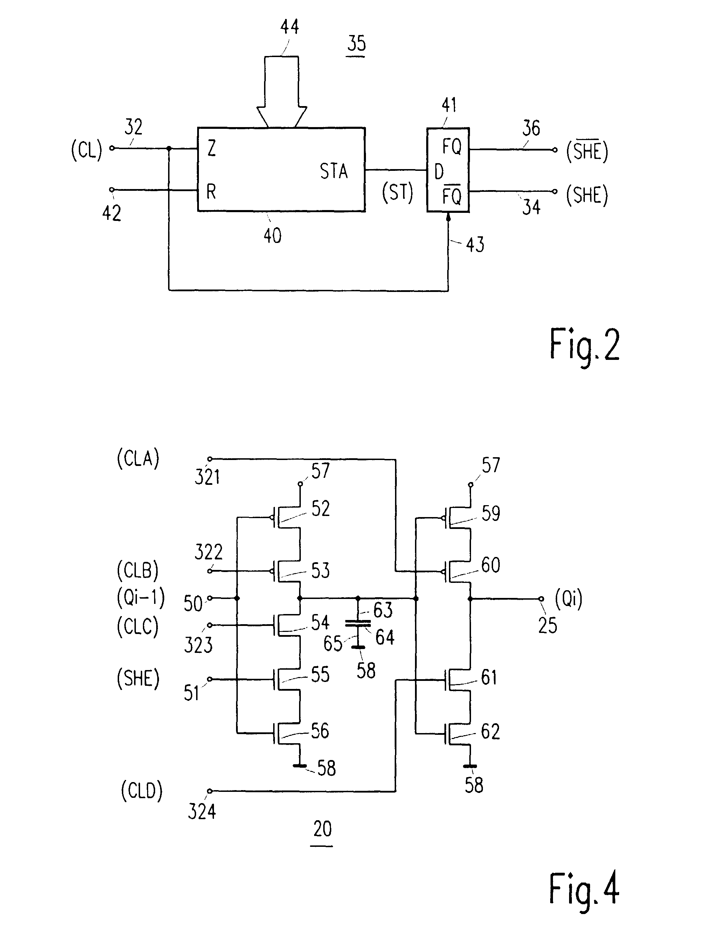

Fig. 2 zeigt blockschematisch ein Ausführungsbeispiel für eine Ausgestaltung der Befehlsanordnung 35, in der das Freigabesignal SHE sowie dessen Inverses erzeugt werden. Die Befehlsanordnung 35 umfaßt nach dieser Ausführungsform eine voreinstellbare Zählvorrichtung 40, deren Zählzyklus auf das gewählte Vielfache der Perioden des Taktsignals CL einstellbar ist. Ihr wird über die Taktleitung 32 an einem Zähleingang Z das Taktsignal CL zugeführt. Nach jedem Zählzyklus gibt die Zählvorrichtung 40 an einem Startsignalausgang STA einen eine Periode des Taktsignals CL dauernden Startimpuls ST ab, der in Fig. 3 ebenfalls über der Zeit t dargestellt ist. Der Startimpuls ST wird einem D-Eingang eines D-Flipflops 41 zugeführt. Der am D-Eingang des D-Flipflops 41 anliegende Signalpegel des Startimpulses ST wird bei der folgenden ansteigenden Flanke des Taktsignals CL, in Fig. 3 also zum Zeitpunkt t2 (wohingegen der erste Startimpuls zum Zeitpunkt t1 beginnt), in das D-Flipflop 41 geladen und liegt entsprechend ab dem Zeitpunkt t2 an einem nicht invertierenden Ausgang FQ des D-Flipflops 41, der mit der Leitung 36 verbunden ist, als Inverses des Freigabesignals SHE an, während er entsprechend an einem invertierenden Ausgang des D-Flipflops 41 der in Fig. 2 mit dem durch das Inversionszeichen ergänzten Bezugszeichen FQ versehen ist, in invertierter Form abgegeben wird. Dieser invertierende Ausgang des D-Flipflops 41 ist mit der Freigabeleitung 34 verbunden; das Signal am invertierenden Ausgang des D-Flipflops 41 bildet somit das Freigabesignal SHE. Über einen Synchronisierungseingang 42, der innerhalb der Befehlsanordnung 35 mit einem Rücksetzeingang R der Zählvorrichtung 40 verbunden ist, kann der Zählvorgang in der Zählvorrichtung 40 bei Bedarf synchronisiert und die Zählvorrichtung 40 außerdem - beispielsweise bei Inbetriebnahme - in einen definierten Zustand versetzt werden. Für eine korrekte Funktionsweise der Befehlsanordnung 35 wird das darin enthaltene D-Flipflop 41 über einen Takteingang 43 durch das Taktsignal CL gesteuert.

Die Zählvorrichtung 40 kann über einen Dateneingang 44 auf einen gewünschten Zählzyklus voreingestellt werden. Sie zählt dann von einem ersten Bezugswert, z.B. Null, bis zu einem über den Dateneingang 44 zugeführten, zweiten Bezugswert und setzt sich unter Abgabe des Startimpulses ST auf den ersten Bezugswert zurück, um erneut bis zum zweiten Bezugswert nach Maßgabe des Taktsignals CL zu zählen. Über den Dateneingang 44 kann somit die gewünschte Verzögerungszeit sehr einfach über digitale Steuersignale vorgegeben und auch während des Betriebs der Schaltungsanordnung rasch und einfach verändert werden.

Das in den Fig. 1 bis 3 dargestellte Ausführungsbeispiel der vorliegenden Erfindung entspricht einer bevorzugten Ausführungsform, in der das der ersten Kippschaltung 20 der Schieberegisteranordnung zugeleitete Freigabesignal dem um eine Periode des Taktsignals CL verschobenen Startimpuls ST und damit dem Inversen des den übrigen Kippschaltungen 20 zugeführten Freigabesignals SHE entspricht.

Fig. 4 zeigt ein Transistorschaltbild eines Ausführungsbeispiels für eine bistabile Kippschaltung 20 mit einer der Ordnungsnummern 2 bis n, d.h. für eine Kippschaltung 20, die ein Und-Gatter 24 enthält. Aus diesem Schaltbild kann die Kippschaltung 20 mit der Ordnungsnummer 1 in einfacher Weise durch Verbindung der Eingänge des Und-Gatters 24 erhalten werden. Diese Eingänge entsprechen im Schaltbild der Fig. 4 einem Anschluß 50 für das Ausgangssignal Qi-1 der in der Kette voraufgehenden Kippschaltung 20, also der Kippschaltung mit der um 1 erniedrigten Ordnungsnummer, bzw. einem Anschluß 51, der mit der Freigabeleitung 34 zum Zuführen des Freigabesignals SHE verbunden ist. Am Q-Ausgang 25 wird das Ausgangssignal Qi abgegeben.

Das in Fig. 4 gezeigte Ausführungsbeispiel der bistabilen Kippschaltung 20 enthält eine erste Reihenschaltung aus fünf Feldeffekttransistoren 52 bis 56, die mit ihren Hauptstrompfaden in Reihe zueinander zwischen einem Versorgungsspannungsanschluß 57 und Masse 58 geschaltet sind, sowie eine zweite Reihenschaltung aus vier Feldeffekttransistoren 59, 60, 61, 62, die ebenfalls untereinander mit ihren Hauptstrompfaden in Reihe und zwischen den Versorgungsspannungsanschluß und Masse geschaltet sind. Dabei sind die Feldeffekttransistoren 52, 53, 59 und 60 vom entgegengesetzten Leitungstyp im Bezug auf die Feldeffekttransistoren 54, 55, 56, 61 und 62 derart, daß ein hoher Signalpegel am Gate-Anschluß der Feldeffekttransistoren 52, 53, 59, 60 die Hauptstrompfade dieser Transistoren sperrt und demgegenüber ein hoher Signalpegel an den Gate-Anschlüssen der übrigen Feldeffekttransistoren 54, 55, 56, 61, 62 deren Hauptstrompfade in den leitenden Zustand schaltet.

Die Gate-Anschlüsse des ersten und des fünften Feldeffekttransistors 52 und 56 der ersten Reihenschaltung sind miteinander und mit dem Anschluß 50 zum Zuführen des Ausgangssignals Qi-1 der voraufgehenden Kippschaltung verbunden, wohingegen der Gate-Anschluß des vierten Feldeffekttransistors 55 mit dem Anschluß 51 für das Freigabesignal SHE verbunden ist. Vom Verbindungspunkt der Hauptstrompfade des zweiten und des dritten Feldeffekttransistors 53 und 54 führt eine Verbindung an die Gate-Anschlüsse des sechsten Feldeffekttransistors 59 und des neunten Feldeffekttransistors 62 der zweiten Reihenschaltung und außerdem an einen Anschluß 63 eines Kondensators 64, dessen zweiter Anschluß 65 mit Masse 58 verbunden ist. Der Q-Ausgang 25 ist mit dem Verbindungspunkt der Hauptstrompfade des siebten und des achten Feldeffekttransistors 60 und 61 verbunden.

Der Gate-Anschluß des siebten Feldeffekttransistors 60 ist mit einem ersten Taktsignaleingang 321 für ein erstes Taktsignal CLA verbunden, wohingegen der Gate-Anschluß des zweiten Feldeffekttransitors 53 an einen zweiten Taktsignaleingang 322 für ein zweites Taktsignal CLB, der Gate-Anschluß des dritten Feldeffekttransistors 54 an einen dritten Taktsignaleingang 323 für ein drittes Taktsignal CLC und der Gate-Anschluß des achten Feldeffekttransistors 61 an einen vierten Taktsignaleingang 324 zum Zuführen eines vierten Taktsignals CLD geführt ist. Durch das zweite und das dritte Taktsignal CLB und CLC am zweiten bzw. dritten Taktsignaleingang 322 bzw. 323 ist die erste Reihenschaltung mit den Feldeffekttransistoren 52 bis 56 über den zweiten und den dritten Feldeffekttransistor 53 bzw. 54 leitend bzw. gesperrt schaltbar, wohingegen das erste und das vierte Taktsignal CLA und CLD die zweite Reihenschaltung aus den Feldeffekttransistoren 59 bis 62 über den siebten bzw. den achten Feldeffekttransistor 60 bzw. 61 wahlweise leitend oder gesperrt schalten können. Im gesperrten Zustand beider Reihenschaltungen nehmen das erste und das zweite Taktsignal CLA und CLB einen hohen Signalpegel ein, während das dritte und vierte Taktsignal CLC und CLD einen niedrigen Signalpegel annehmen. Dann sind der zweite, dritte, siebte und achte Feldeffekttransistor 53, 54, 60 bzw. 61 gleichermaßen gesperrt, und der Kondensator 64 sowie der Q-Ausgang 25 sind von der Ladungszu- bzw. abfuhr vom bzw. zum Versorgungsspannungs- bzw. Masseanschluß 57 bzw. 58 abgetrennt. Damit bleibt der Ladungszustand, d.h. die im Kondensator 64 gespeicherte (binäre) Information unverändert erhalten.

Für eine Einspeicherung neuer Information, wie sie z.B. beim Durchschieben des Startimpulses durch die Schieberegisteranordnung der Fig. 1 in den einzelnen Kippschaltungen 20 vorzunehmen ist, wird in einem ersten Schritt der Pegel des zweiten Taktsignals CLB auf einen niedrigen und der Pegel des dritten Taktsignals CLC auf einen hohen Wert umgeschaltet. Damit werden der zweite und der dritte Feldeffekttransistor 53, 54 leitend. In Abhängigkeit von den Signalpegeln an den Anschlüssen 50 und 51 für das Ausgangssignal Qi-1 bzw. das Freigabesignal SHE wird der Kondensator 64 nun entweder auf den Signalpegel vom Versorgungsspannungsanschluß 57 aufgeladen oder auf den Signalpegel von Masse 58 entladen. Eine Entladung erfolgt, wenn an den Anschlüssen 50, 51 zugleich ein hoher Signalpegel angelegt wird, wohingegen bei einem niedrigen Signalpegel am Anschluß 50 eine Aufladung des Kondensators 64 stattfindet. Durch Übergang der Signalpegel des zweiten und dritten Taktsignals CLB und CLC zu ihren ursprünglichen Werten wird die erste Reihenschaltung wieder gesperrt und die Ladung auf dem Kondensator 64 festgehalten.

In einem zweiten Schritt wird nun durch Übergang des ersten Taktsignals CLA auf einen niedrigen Signalpegel und des vierten Taktsignals CLD auf einen hohen Signalpegel die zweite Reihenschaltung leitend geschaltet. Der Signalpegel, d.h. der Ladezustand des Kondensators 64 entscheidet dann darüber, ob - bei hohem Signalpegel - der Q-Ausgang 25 mit Masse 58 oder - bei niedrigem Signalpegel - mit dem Versorgungsspannungsanschluß 57 verbunden und die entsprechenden Pegel dem Q-Ausgang 25 als Ausgangssignal Qi zugeführt werden. Der Signalpegel am Kondensator 64 wird somit invertiert am Q-Ausgang 25 abgegeben.

Die vier Taktsignale CLA, CLB, CLC und CLD können aus dem Taktsignal CL, z.B aus dessen Halbperioden, abgeleitet werden. Der ansteigenden Flanke des Taktsignals CL entspricht dann im wesentlichen der Übergang des ersten Taktsignals CLA von hohem zu niedrigem Signalpegel sowie der gleichzeitige Übergang des vierten Taktsignals CLD von niedrigem zu hohem Signalpegel.

Die beschriebene, erfindungsgemäße Schaltungsanordnung zum Verzögern eines Nutzsignals wird vorteilhaft für Verzögerungsleitungen im Videofrequenzbereich eingesetzt. Bei diesen Anwendungen werden aufgrund der unterschiedlichen Fernsehnormen verschiedene Verzögerungszeiten benötigt, zwischen den in einem Mehrnormen-Empfangsgerät auch während des Betriebes wahlweise umgeschaltet werden muß. Außerdem können Verzögerungsleitungen mit adaptierbarer Verzögerungszeit aufgebaut werden, die für Dekoder für im Zeitmultiplex übertragene Videosignale wie z.B. die D2MAC-Norm, für Kompressions- und Dekompressionsschaltungen für Bildformatkonvertierung, in der Echounterdrückung für die Fernsehübertragung sowie in Multistandard-Video-Kammfiltern Verwendung finden. Dabei erfolgt die Adaption der Verzögerungszeit bei der erfindungsgemäßen Schaltungsanordnung vollkommen störungsfrei.

## Patentansprüche

1. Schaltungsanordnung zum Verzögern eines Nutzsignals, welches in Form zeitdiskreter Signalproben in durch ein Taktsignal (CL) vorgegebenen Zeitabständen in einer Reihe von Speicheranordnungen (11) gespeichert und aus diesen nach Ablauf einer vorgebbaren Verzögerungszeit wieder ausgelesen wird, wofür jede Speicheranordnung (11) über je eine Eingabeschaltung (12) mit einem Nutzsignaleingang (30) und über je eine Ausgabeschaltung (13) mit einem Nutzsignalausgang (31) verbindbar und die Eingabeschaltung (12) je einer Speicheranordnung (11) gemeinsam mit der Ausgabeschaltung (13) der in der Reihe nachfolgenden Speicheranordnung (11) durch je eine Ansteuervorrichtung (14, 15, 20) betätigbar ist, mit einer aus einer Kette von bistabilen Kippschaltungen (20) gebildeten Schieberegisteranordnung, in der der Ausgang (25) je einer der Kippschaltungen (20) mit dem Eingang der in der Kette nachfolgenden Kippschaltung (20) verbunden ist, jede Ansteuervorrichtung (14, 15, 20) je eine der Kippschaltungen (20) umfaßt und alle Kippschaltungen (20) vom Taktsignal (CL) geschaltet werden, und mit einer Befehlsanordnung (35), die zu einem ersten Zeitpunkt (tl) der ersten Kippschaltung (20) in der Schieberegisteranordnung einen ersten Startimpuls (ST) zuleitet und die Schieberegisteranordnung für eine Weiterleitung des Startimpulses (ST) durch die Kette der Kippschaltungen (20) nach Maßgabe des Taktsignals (CL) freigibt, und die zu einem zweiten Zeitpunkt (t10) die Weiterleitung des ersten Startimpulses (ST) unterbricht und zugleich der ersten Kippschaltung (20) in der Schieberegisteranordnung einen nächsten Startimpuls (ST) zuleitet und die Schieberegisteranordnung für die Weiterleitung dieses nächsten Startimpulses (ST) erneut freigibt, wobei die Zeitspanne zwischen dem ersten (tl) und dem zweiten (t10) Zeitpunkt ein wählbares, ganzzahliges Vielfaches von Perioden des Taktsignals (CL) beträgt und die Anzahl (n) der Speicheranordnungen (11) bzw. der Kippschaltungen (20) mindestens diesem Vielfachen (n) der Perioden des Taktsignals (CL) entspricht.

2. Schaltungsanordnung nach Anspruch 1,
dadurch gekennzeichnet, daß die Befehlsanordnung (35)eine voreinstellbare Zählvorrichtung (40) umfaßt, deren Zählzyklus auf das gewählte Vielfache der Perioden des Taktsignals (CL) einstellbar ist und die nach jedem Zählzyklus einen der Startimpulse (ST) abgibt.

3. Schaltungsanordnung nach Anspruch 1 oder 2,
dadurch gekennzeichnet, daß die Kippschaltungen (20) je ein vom Taktsignal (CL) gemeinsam getaktetes D-Flipflop (21) umfassen.

4. Schaltungsanordnung nach Anspruch 3,
dadurch gekennzeichnet, daß dem Eingang (23) jedes D-Flipflops (21) ein Und-Gatter (24) vorgeschaltet ist, in dem das Ausgangssignal (Qi-1) der voraufgehenden Kippschaltung (20) mit einem Freigabesignal (SHE) von der Befehlsanordnung (35) verknüpft wird.

5. Schaltungsanordnung nach Anspruch 4,
dadurch gekennzeichnet, daß der ersten Kippschaltung (20) der Schieberegisteranordnung das Inverse des den übrigen Kippschaltungen (20) zugeführten Freigabesignals (SHE) zugeleitet wird.

6. Schaltungsanordnung nach Anspruch 5,
dadurch gekennzeichnet, daß das der ersten Kippschaltung (20) der Schieberegisteranordnung zugeleitete Freigabesignal dem um eine Periode des Taktsignals verschobenen Startimpuls (ST) entspricht.

## Claims

1. A circuit arrangement for delaying a useful signal which is stored in the form of time-discrete signal samples in a row of storage devices (11) at time intervals determined by a clock signal (CL) and is read therefrom after expiration of a selectable delay time, each storage device (11) being connectable, *via* a respective input circuit (12), to a useful signal input (30) and, *via* a respective output circuit (13), to a useful signal output (31) for this purpose, the input circuit (12) of each storage device (11) being activatable, together with the output circuit (13) of the next storage device (11) in the row, by a respective activation device (14, 15, 20), comprising a shift register device formed by a chain of bistable trigger circuits (20) in which the output (25) of each of the trigger circuits (20) is connected to the input of the next trigger circuit (20) in the chain, each activation device (14, 15, 20) comprising one of the trigger circuits (20) and all trigger circuits (20) being switched by the clock signal (CL), and also comprising a command device (35) which applies a first start pulse (ST) to the first trigger circuit (20) in the shift register device at a first instant (t1), enables the shift register device to propagate the start pulse (ST) through the chain of trigger circuits (20) in conformity with the clock signal (CL), and interrupts the propagation of the first start pulse (ST) at a second instant (t10) and at the same time applies a next start pulse (ST) to the first trigger circuit (20) in the shift register device and enables the shift register device again to propagate said next start pulse (ST), the time interval between the first instant (t1) and the second instant (t10) amounting to a selectable, integer multiple of periods of the clock signal (CL), the number (n) of storage devices (11) or trigger circuits (20) corresponding at least to said multiple (n) of the periods of the clock signal (CL).

2. A circuit arrangement as claimed in Claim 1, characterized in that the command device (35) comprises a presettable counting device (40) whose counting cycle can be adjusted to the selected multiple of the periods of the clock signal (CL) and outputs one of the start pulses (ST) after each counting cycle.

3. A circuit arrangement as claimed in Claim 1 or 2, characterized in that the trigger circuits (20) comprise a respective D-flipflop (21) clocked in common by the clock signal (CL).

4. A circuit arrangement as claimed in Claim 3, characterized in that the input (23) of each D-flipflop (21) is preceded by an AND-gate (24) in which the output signal (Qi-1) of the preceding trigger circuit (20) is combined with an enable signal (SHE) from the command device (35).

5. A circuit arrangement as claimed in Claim 4, characterized in that the first trigger circuit (20) of the shift register device receives the inverse of the enable signal (SHE) applied to the other trigger circuits (20).

6. A circuit arrangement as claimed in Claim 5, characterized in that the enable signal applied to the first trigger circuit (20) of the shift register device corresponds to the start pulse (ST) shifted by one period of the clock signal.

## Revendications

1. Circuit de retardement d'un signal utile qui est enregistré sous la forme d'échantillons de signaux discrets dans le temps à des intervalles temporels préalablement déterminés par un signal de rythme (CL) dans une série de dispositifs de mémoire (11) et, à partir de ceux-ci, est lu à nouveau après l'expiration d'un temps de retard à déterminer préalablement, chaque dispositif de mémoire (11) pouvant être relié par l'intermédiaire d'un circuit d'entrée (12) avec une entrée de signal utile (30) et par l'intermédiaire d'un circuit de sortie (13) avec une sortie de signal utile (31) et le circuit d'entrée (12) d'un dispositif de mémoire (11) respectif pouvant être actionné en même temps que le circuit de sortie (13) du dispositif de mémoire (11) suivant en série par un dispositif d'excitation (14, 15, 20) avec un dispositif de registre à décalage formé à partir d'une chaîne de bascules bistables (20), dispositif dans lequel la sortie (25) d'une des bascules respectives (20) est reliée à l'entrée de la bascule suivante (20) dans la chaîne, chaque dispositif d'excitation (14, 15, 20) comprenant respectivement l'une des bascules (20) et toutes les bascules (20) étant commutées par le signal de rythme (CL) et avec un dispositif de transmission d'instructions (35) qui, dans un premier temps (t1), amène à la première bascule (20) dans le dispositif de registre à décalage une (première) impulsion de départ (ST) et libère le dispositif de registre à décalage pour le transfert de l'impulsion de départ (ST) par la chaîne des bascules (20) en fonction du signal de rythme (CL) et, dans un deuxième temps (t10), interrompt le transfert de la (première) impulsion de départ (ST) et amène à la fois la première bascule (20) dans le dispositif de registre à décalage une impulsion de départ suivante (ST) et libère à nouveau le dispositif de registre à décalage pour le transfert de cette impulsion de départ (ST) suivante, l'intervalle entre les premier (t1) et deuxième (t2) moments étant un multiple entier au choix de périodes du signal de rythme (CL) et le nombre (n) de dispositifs de mémoire (11) et de bascules (20) correspondant au moins à ce multiple (n) des périodes du signal de rythme (CL).

2. Circuit selon la revendication 1,
caractérisé en ce que le dispositif de transmission d'instructions (35) comprend un iispositif de comptage (40) à régler préalablement dont le cycle de comptage peut être réglé au multiple souhaité des périodes du signal de rythme (CL) et qui délivre l'une des impulsions de départ (ST) après chaque cycle de comptage.

3. Circuit selon l'une des revendications 1 ou 2,
caractérisé en ce que les bascules (5) comprennent respectivement un flipflop D (21) cadencé en même temps par le signal de rythme (CL).

4. Circuit selon la revendication 3,
caractérisé en ce qu'une grille ET (24) est montée en amont de l'entrée (23) de chaque flipflop D (21), grille dans laquelle le signal de sortie (Qi-1) de la bascule précédente (20) est associé à un signal de libération (SHE) du dispositif de transmission d'instructions (35).

5. Circuit selon la revendication 4,
caractérisé en ce que l'inverse du signal de libération (SHE) amené aux autres bascules (20) est transmis à la première bascule (20) du dispositif de registre à décalage.

6. Circuit selon la revendication 5,
caractérisé en ce que le signal de libération amené à la première bascule (20) du dispositif de registre à décalage correspond à l'impulsion de départ (ST) décalée d'une période de signal de rythme.
